# EUROPÄISCHE PATENTSCHRIFT

(11) **EP 2 947 703 B1**
(45) Veröffentlichungstag und Bekanntmachung des Hinweises auf die Patenterteilung: **17.04.2019**
(21) Anmeldenummer: 14001786.4
(22) Anmeldetag: 21.05.2014
(51) Int. Cl.: H01L 31/0687

(54) **Solarzellenstapel**
Solar cell stack
Empilement de cellules solaires

(43) Veröffentlichungstag der Anmeldung: 25.11.2015
(73) Patentinhaber: AZUR SPACE Solar Power GmbH, 74072 Heilbronn (DE)
(72) Erfinder: Guter, Wolfgang, 70190 Stuttgart (DE); Meusel, Matthias, 74076 Heilbronn (DE)
(74) Vertreter: Koch Müller Patentanwaltsgesellschaft mbH

(56) Entgegenhaltungen:
- EP-A1- 2 610 924
- US-A1- 2009 229 659
- V. KLINGER ET AL: "Determination of hardness and Young's modulus for important III-V compound semiconductors", THIN SOLID FILMS, Bd. 548, 29. August 2013 (2013-08-29), Seiten 358-365, XP055156264, ISSN: 0040-6090, DOI: 10.1016/j.tsf.2013.08.079
- TYLER J GRASSMAN ET AL: "Expanding the palette: Metamorphic strategies over multiple lattice constant ranges for extending the spectrum of accessible photovoltaic materials", PHOTOVOLTAIC SPECIALISTS CONFERENCE (PVSC), 2011 37TH IEEE, IEEE, 19. Juni 2011 (2011-06-19), Seiten 3375-3380, XP032168414, DOI: 10.1109/PVSC.2011.6186671 ISBN: 978-1-4244-9966-3
- HECTOR COTAL ET AL: "III-V multijunction solar cells for concentrating photovoltaics", ENERGY & ENVIRONMENTAL SCIENCE, Bd. 2, Nr. 2, 10. Dezember 2008 (2008-12-10), Seiten 174-192, XP055033873, ISSN: 1754-5692, DOI: 10.1039/b809257e

## Beschreibung

Die Erfindung betrifft einen Solarzellenstapel gemäß dem Oberbegriff des Patentanspruchs 1.

Bei der Epitaxie von III-V Mehrfach-Solarzellen werden so genannte metamorphe Puffer verwendet, um auf den metamorphen Puffern Halbleiterschichten aus Materialien mit einer anderen Gitterkonstanten als die des Substrates bzw. von unterhalb des Puffers liegenden Schichten mit hoher Qualität abzuscheiden. Durch den metamorphen Puffer wird ein so genanntes virtuelles Substrat mit anderer Gitterkonstante als die des ursprünglichen Substrates gebildet. Hierdurch lässt sich der Spielraum für eine Wahl von Materialien insbesondere für die verschiedenen Elemente einer Mehrfach-Solarzelle vergrößern und den Wirkungsgrad der Mehrfach-Solarzelle erhöhen.

Es ist wünschenswert, dass die Gitterkonstante des metamorphen Puffers während der Herstellung im Allgemeinen vergrößert wird. Hierdurch sind die meisten Schichten des Puffers kompressiv verspannt, wobei sich in einem Vergleich zu einem tensil verspannten Puffer die Versetzungen homogener ausbilden und insbesondere weniger Risse entstehen. Außerdem ist es wünschenswert, dass alle Schichten des metamorphen Puffers für Licht bestimmter Wellenlängen transparent sind, so dass sich Licht in den weiteren Solarzellen zur photoelektrischen Energiekonversion nutzen lässt.

Aus A. Zakaria, Richard R. King, M. Jackson, and M. S. Goorsky; Comparison of arsenide and phosphide based graded buffer layers used in inverted metamorphic solar cells; J. Appl. Phys. 112, 024907 (2012) sind mehrere Solarzellenstapel mit jeweils einem metamorphen Puffer bekannt. Des Weiteren sind aus US 2013 / 0312818 A1 Solarzellenstapel mit metamorphen Puffern bekannt. Auch in W. Guter, J. Schöne, S. P. Philipps, M. Steiner, G. Siefer, A. Wekkeli, E. Weiser, E. Olivia, A. Bett und F. Dimroth; Current-matched triple-junction solar cell reaching 41.1 % conversion efficiency under concentrated sunlight; Applied Physics Letters 94, 223504, 2009; sind Solarzellenstapel wie vorliegend in der Figur 3 abgebildet, offenbart. Aus der EP 2 610 924 A1 ist ebenfalls ein metamorpher Puffer bekannt.

Weitere Solarzellenstapel mit metamorphen Puffern sind aus J. Schöne, "Kontrolle von Spannungsrelaxation und Defektbildung in metamorphen III-V Halbleiterheterostrukturen für hocheffiziente Halbleiter-Solarzellen, Dissertation 2009, Technische Fakultät Kiel, offenbart.

Ferner ist es bei den metamorphen Puffern wünschenswert, Gitterverspannungen durch Bildung von Versetzungen oder anderen Kristalldefekten bereits in den Puffern abzubauen, wobei die Kristalldefekte möglichst in dem Puffer lokalisiert werden. Insbesondere sollen Fadenversetzungen daran gehindert werden, in andere Teile des Halbleiterschichtstapels vorzudringen. Hierzu ist es bevorzugt in den metamorphen Puffern die Härte der Pufferschichten mit-der Gitterkonstante ansteigen zu lassen, um insbesondere die Ausbreitung von Versetzungen in darüber liegende Schichten zu reduzieren und /oder die Relaxation von darüber liegenden Schichten zu erschweren. Im Unterschied hierzu wird von V. Klinger, T. Rösener, G. Lorenz, M. Petzold und F. Dimroth; Elastische und plastische Eigenschaften von III-V Halbleitern für metamorphe Pufferstrukturen; 27. DGKK Workshop - Epitaxie von III/V -Halbleitern - Erlangen, 6./7. Dezember 2012; offenbart, dass für einen metamorphen Puffer bei der quaternären Verbindung Al0.4InxGa0.6-xAs (0<x<0.6) bei dem das Element Gallium sukzessive durch Indium ersetzt wird, die Gitterkonstante mit dem In-Gehalt ansteigt, während die Nanohärte abnimmt.

Vor diesem Hintergrund besteht die Aufgabe der Erfindung darin, eine Vorrichtung anzugeben, die den Stand der Technik weiterbildet.

Die Aufgabe wird durch einen Solarzellenstapel mit den Merkmalen des Patentanspruchs 1 gelöst. Vorteilhafte Ausgestaltungen der Erfindung sind Gegenstand von Unteransprüchen.

Gemäß dem Gegenstand der Erfindung wird ein Solarzellenstapel bereitgestellt, mit einer ersten Halbleiter-Solarzelle, wobei die erste Halbleiter-Solarzelle einen p-n Übergang aus einem ersten Material mit einer ersten Gitterkonstanten aufweist, und mit einer zweiten Halbleiter-Solarzelle, wobei die zweite Halbleiter-Solarzelle einen p-n Übergang aus einem zweiten Material mit einer zweiten Gitterkonstanten aufweist, und wobei die erste Gitterkonstante kleiner als die zweite Gitterkonstante ist, und der Solarzellenstapel einen metamorphen Puffer aufweist wobei der metamorphe Puffer eine Abfolge von aufeinanderfolgenden Schichten mit einer ersten unteren Schicht und einer zweiten mittleren Schicht und einer dritten oberen Schicht umfasst und der metamorphe Puffer eine InGaAs und/oder eine AlInGaAs und/oder eine InGaP und/oder eine AlInGaP-Verbindung umfasst und der metamorphe Puffer zwischen der ersten Halbleiter-Solarzelle und der zweiten Halbleiter-Solarzelle ausgebildet ist und bei dem metamorphen Puffer sich entlang seiner Dickenerstreckung die Gitterkonstante ändert, und wobei die zweite Schicht einen höheren Al - Gehalt, als die erste Schicht und als die dritte Schicht aufweist und / oder die zweite Schicht einen geringeren Phosphorgehalt als die erste Schicht und die dritte Schicht eine Phosphid-Verbindung aufweist, und die Gitterkonstante der dritten Schicht größer als die Gitterkonstante der zweiten Schicht und die Gitterkonstante der zweiten Schicht größer als die Gitterkonstante der ersten Schicht ist.

Es sei angemerkt, dass die Anzahl der Schichten der metamorphen Puffer wenigstens drei beträgt, jedoch je nach Anwendungsfall auch eine Anzahl von sechs Schichten oder bis zu dreißig oder mehr einzelnen Schichten herstellbar sind. Des Weiteren sei angemerkt, dass die einzelnen Schichten der metamorphen Puffer im Allgemeinen dünn vorzugsweise unterhalb 600 nm, höchst vorzugsweise unterhalb 300 nm ausgebildet sind. Des Weiteren bezieht sich die Gitterkonstante eines Materials immer auf den unverspannten Zustand. Insbesondere sind grundsätzlich an der Fügungsstelle zwischen zwei Schichten die lateralen (in-plane) Gitterkonstanten der beiden aneinanderliegenden Schichten nahezu identisch, während sich die vertikalen (out-of-plane) Gitterkonstanten und die Gitterkonstante im unverspannten Fall unterscheiden.

Ein Vorteil der erfindungsgemäßen Vorrichtung ist es, dass mittels des hohen Al-Gehaltes in der zweiten Schicht des metamorphen Puffers trotz einer weiter ansteigenden Gitterkonstante zu einer Ausbildung von einer besonders weichen Schicht, d.h. einer Schicht mit einer geringen Nanohärte, innerhalb des Puffers kommt. Hierdurch wird eine Bildung von Fehlanpassungsversetzungen in der zweiten Schicht erleichtert. Insbesondere haben Untersuchungen gezeigt, dass in der zweiten Schicht die Versetzungen bevorzugt ausbilden und in der zweiten Schicht verbleiben und nicht zu den unterhalb und / oder zu den oberhalb liegenden aktiven Schichten der Halbleitersolarzellen vordringen. Hierdurch werden eine unerwünschte Reduktion der Ladungsträger in den aktiven Schichten und eine Verringerung des Wirkungsgrades der Halbleitersolarzellen in dem Solarzellenstapel verhindert. Anders ausgedrückt wird mit der Einführung der zweiten Schicht mit einem höheren Al-Gehalt als die erste Schicht und die dritte Schicht und gegebenenfalls im Vergleich zu weiteren Schichten des metamorphen Puffers eine Art "Sollbruchstelle" eingeführt, indem die zweite Schicht besonderes weich ausgebildet ist. Unter einer weichen Schicht wird vorliegend eine geringere Nanohärte der ausgewählten Schicht in einem Vergleich zu den umgebenden Schichten des metamorphen Puffers verstanden.

Ein weiterer Vorteil ist, dass sich mit der Einführung der zweiten Schicht eine Verbiegung des Halbleitersubstrates durch die Einwirkung von kompressiven oder tensilen Stress verringert wird. Insbesondere bei dem Aufwachsen der weiteren Schichten bei der Epitaxie werden eine bessere Homogenität und eine bessere Reproduzierbarkeit des Schichtwachstums erreicht und sämtliche Schichten des Solarzellenstapels sind in situ herstellbar. Hierdurch lassen sich Halbleiter-Solarzellen mit sehr unterschiedlichen Gitterkonstanten bzw. Bandabstand, nachfolgend auch als Energie der Bandlücken bezeichnet, einfach und kostengünstig und mit hohem Wirkungsgrad in Rahmen eines Epitaxieprozesses aufeinander wachsen. Die Fehlstellen oder Versetzungen innerhalb der Halbleiter-Solarzellen werden zuverlässig von der "Soll-Bruchstelle" unterdrückt.

Ein anderer Vorteil ist, dass der Solarzellenstapel nach dessen Herstellung eine geringere Restspannung aufweist. Dies führt zu einer höheren Betriebssicherheit und höhere Wirkungsgraden bei den Solarzellenstapeln.

Ein weiterer Vorteil ist, dass sich mehrere Halbleiter-Solarzellen mit unterschiedlichen Gitterkonstanten und Bandlücken einfach zusammenfügen lassen. Ein Vorteil ist, dass sich die einzelnen Halbleitersolarzellen mit den Bandlücken derart zu dem Solarzellenstapel zusammenfügen lassen, dass sich der Gesamtwirkungsgrad des Solarzellenstapels erhöht.

In einer bevorzugten Ausführungsform steigt die Gitterkonstante des metamorphen Puffers in Richtung der zweiten Halbleitersolarzelle von Schicht zu Schicht vorzugsweise um jeweils mindestens 0,003 Ä, höchstvorzugsweise um jeweils mindestens 0,005 Å an.

In einer Weiterbildung weist eine Schicht des metamorphen Puffers eine dritte Gitterkonstante auf. Die dritte Gitterkonstante ist größer als die Gitterkonstante der zweiten Halbleiter-Solarzelle. Untersuchungen haben gezeigt, dass sich hierdurch die Relaxation des metamorphen Puffers weiter verbessert lässt.

In einer Weiterbildung weist die zweite Schicht eine größere Gitterkonstante als die erste Halbleitersolarzelle auf. In einer Ausführungsform ist eine vierte Schicht bei dem metamorphen Puffer vorgesehen, wobei die vierte Schicht oberhalb der dritten Schicht angeordnet und stoffschlüssig mit der dritten Schicht verbunden ist. Ferner weist die vierte Schicht eine kleinere Gitterkonstante als die zweite Halbleitersolarzelle auf.

In einer Ausführungsform weist die zweite Schicht des metamorphen Puffers eine gleich große Gitterkonstante wie die zweite Halbleitersolarzelle auf oder in einer weiteren Alternative weist die zweite Schicht des metamorphen Puffers eine um maximal 0,008 Å größere Gitterkonstante als die zweite Halbleitersolarzelle auf.

In einer bevorzugten Weiterbildung ist der Al-Gehalt der zweiten Schicht größer als der Al-Gehalt aller anderen Schichten des metamorphen Puffers. Untersuchungen haben gezeigt, dass die weichste Schicht an einer vorgegebenen Position innerhalb des metamorphen Puffers ausbilden lässt und sich die Versetzungen vorzugsweise an einer vorgegeben Stelle in dem Puffer ausbilden.

In einer Weiterbildung sind innerhalb der Abfolge von drei Schichten des metamorphen Puffers nur InGaAs-Schichten und / oder AlInGaAs-Schichten ausgebildet. In einer alternativen Ausführungsform sind innerhalb der Abfolge von drei Schichten des metamorphen Schichten nur InGaP-Schichten und/oder AlInGaP-Schichten ausgebildet. Es versteht sich, dass zusätzlich zu den Verbindungen InGaAs, AlInGaAs, InGaP und AlInGaP jeweils weitere zusätzliche Stoffe ausbilden lassen.

In einer Ausführungsform sind die erste Schicht mit der zweiten Schicht und die zweite Schicht mit der dritten Schicht jeweils stoffschlüssig verbunden. In einer Weiterbildung weist die erste Schicht und die dritte Schicht eine größere Nanohärte als die zweite Schicht auf. Hierdurch wird eine Weiterführung der Versetzungen aus der zweiten Schicht hinaus in die umgebenden Schichten wirkungsvoll unterdrückt.

In einer anderen Ausführungsform ist eine dritte Halbleiter-Solarzelle vorgesehen, wobei zwischen der zweiten Halbleiter-Solarzelle und der dritten Halbleiter-Solarzelle ein weiterer metamorpher Puffer ausgebildet ist. Anders ausgedrückt in dem gesamten Solarzellenstapel sind zwei von räumlich von einander getrennte metamorphe Puffer ausgebildet. In einer anderen Ausführungsform ist eine Abfolge von zwei metamorphen Puffern zwischen zwei Halbleiter-Solarzellen ausgebildet. Insbesondere ist zwischen der ersten Halbleiter-Solarzelle und der zweiten Halbleiter-Solarzelle zusätzlich zu dem metamorphen Puffer ein weiterer metamorpher Puffer ausgebildet ist Des Weiteren ist bevorzugt, dass jede der Halbleiter-Solarzelle einen pn-Übergang beinhaltet. Des Weiteren sei angemerkt, dass die metamorphen Pufferschichten nicht Teil eines pn-Übergangs einer Tunneldiode sind.

In einer anderen Weiterbildung weist die zweite Schicht keine Nitridverbindung auf. Hierdurch wird vermieden, dass die besonders niedrige Nanohärte der zweiten Schicht erhöht wird.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die laterale und die vertikale Erstreckungen sind nicht maßstäblich und weisen, sofern nicht anders angegeben, auch keine ableitbaren geometrischen Relationen zueinander auf. Darin zeigt die:
- Figur 1: eine erste erfindungsgemäße Ausführungsform eines Solarzellenstapels mit einem metamorphen Puffer,
- Figur 2: eine Abfolge mit zwei aufeinander folgenden metamorphen Puffern,
- Figur 3: eine Darstellung von metamorphen Puffern gemäß des Standes der Technik.

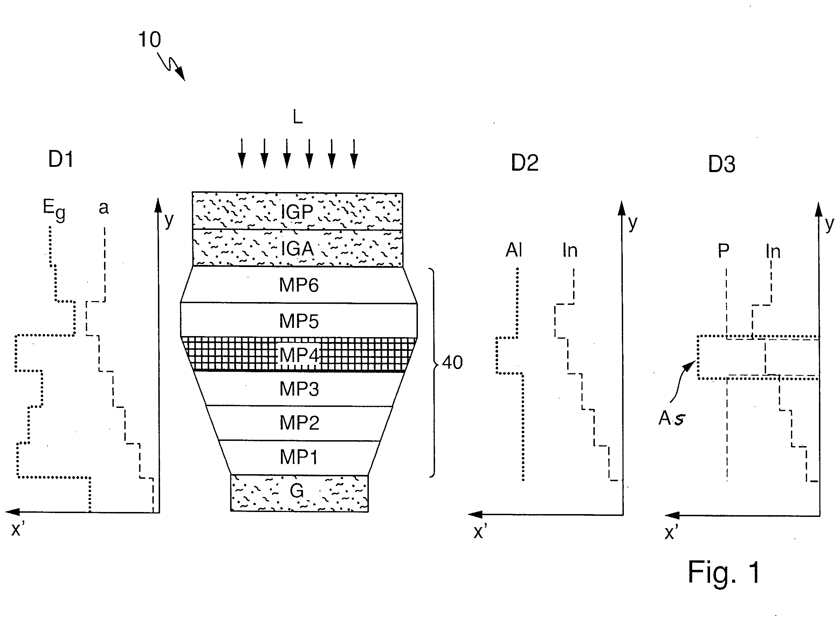

Die Abbildung der Figur 1 zeigt eine schematische Ansicht einer ersten Ausführungsform, aufweisend einen Solarzellenstapel 10 mit einer ersten Halbleiter-Solarzelle G, wobei die erste Halbleiter-Solarzelle G einen p-n Übergang aus einem ersten Material mit einer ersten Gitterkonstanten aufweist - dargestellt in einer Abbildung D1, und mit einer zweiten Halbleiter-Solarzelle IGA und einer dritten Halbleiter-Solarzelle IGP, wobei die zweite Halbleiter-Solarzelle IGA einen p-n Übergang aus einem zweiten Material mit einer zweiten Gitterkonstanten aufweist - dargestellt in einer Abbildung D1, und wobei die erste Gitterkonstante kleiner als die zweite Gitterkonstante ist. Zwischen der ersten Halbleiter-Solarzelle G und der zweiten Halbleiter-Solarzelle IGA des Solarzellenstapels 10 ist ein metamorpher Puffer 40 ausgebildet, um zwischen den unterschiedlichen Gitterkonstanten der beiden Halbleiter-Solarzellen G und IGA zu vermitteln. Der Lichteinfall L in den Solarzellenstapel 10 findet durch die zweite Halbleiter-Solarzelle IGA statt. Es versteht sich, dass die Bezeichnungen der einzelnen Solarzellen G, IGA, IGP auf die vorzugsweise verwendeten chemischen Stoffe hinweisen, d.h. G steht für Germanium, IGA für Indium-Gallium-Arsenid und IGP für Indium-Gallium-Phosphid. Im Folgenden weist GA auf Gallium-Arsenid und IGA1 und IGA2 auf unterschiedliche Kompositionen d.h. Stöchiometrien im Vergleich zu einander und in Vergleich zu der IGA Solarzelle hin.

In einer nicht dargestellten Ausführungsform sind zwischen der ersten Halbleiter-Solarzelle G und dem metamorphen Puffer 40 eine oder mehrere Zwischenschichten, vorzugsweise mit der gleichen Gitterkonstante a wie die erste Halbleiter-Solarzelle G ausgebildet. Ferner sind zwischen dem ersten metamorphen Puffer 40 und der zweiten Halbleitersolarzelle IGA eine oder mehrere zweite Zwischenschichten ausgebildet.

Bei der Darstellung der einzelnen Schichten ist die dargestellte Breite der jeweiligen Schicht ein Maß für die Gitterkonstante jeweiligen Schicht. Bei den einzelnen Schichten ist die Gitterkonstante teilweise als konstant als auch über die Dicke der Schicht als zunehmend oder als abnehmend dargestellt. Es versteht sich, dass an der Grenzfläche zwischen zwei Schichten die in-plane Gitterkonstanten der aufeinandertreffenden Schichten in etwa gleich sind.

Vorliegend besteht der erste metamorphe Puffer 40 aus insgesamt sechs einzelnen Pufferschichten. Auf der ersten Halbleiter-Solarzelle G ist eine erste metamorphe Pufferschicht MP1 des metamorphen Puffers 40 mit einer etwas größeren Gitterkonstante a als die Gitterkonstante a der ersten Halbleiter-Solarzelle G ausgebildet. Aufliegend auf der ersten Pufferschicht MP1 ist eine zweite metamorphe Pufferschicht MP2 mit einer etwas größeren Gitterkonstante als die Gitterkonstante der ersten metamorphen Pufferschicht MP1 ausgebildet. Aufliegend auf der zweiten Pufferschicht MP2 ist eine dritte metamorphe Pufferschicht MP3 mit einer etwas größeren Gitterkonstante als die Gitterkonstante der zweiten metamorphen Pufferschicht MP2 ausgebildet. Aufliegend auf der dritten Pufferschicht MP3 ist eine vierte metamorphe Pufferschicht MP4 mit einer etwas größeren Gitterkonstante als die Gitterkonstante der dritten metamorphen Pufferschicht MP3 ausgebildet. Aufliegend auf der vierten Pufferschicht MP4 ist eine fünfte metamorphe Pufferschicht MP5 mit einer etwas größeren Gitterkonstante als die Gitterkonstante der vierten metamorphen Pufferschicht MP4 ausgebildet. Aufliegend auf der fünften Pufferschicht MP5 ist eine sechste metamorphe Pufferschicht MP6 mit einer etwas kleineren Gitterkonstante als die Gitterkonstante der fünften metamorphen Pufferschicht MP5 ausgebildet. Aufliegend auf der sechsten Pufferschicht MP6 ist die zweite Halbleiter-Solarzelle IGA ausgebildet.

Zur Verdeutlichung der erfindungsgemäßen Ausführungsform sind parallel zu dem Solarzellenstapel 10 sind in einem ersten Diagramm D1 und in einem zweiten Diagramm D2 und in einem dritten Diagramm D3 ausgewählte physikalische Parameter für den Bereich des metamorphen Puffers 40 und der ersten Halbleiter-Solarzelle G und teilweise für die zweite Halbleiter-Solarzelle IGA aufgetragen. In dem ersten Diagramm D1 sind entlang der X-Achse die Größe der Gitterkonstante a und die Größe der Bandlücke Eg und entlang der Y-Achse die Abfolge der einzelnen Schichten aufgetragen. In dem zweiten Diagramm D2 sind entlang der X-Achse der Indium-Gehalt und die der Aluminium-Gehalt und entlang der Y-Achse die Abfolge der einzelnen Schichten abgebildet. Ferner sind in dem dritten Diagramm D3 entlang der X-Achse der Arsen-Gehalt, der Phosphor-Gehalt und der Indium-Gehalt aufgetragen. In den beiden Diagrammen D2 und D3 sind die einzelnen Dotierstoffverläufe mit den chemischen Zeichen referenziert. Nachfolgend wird bei der Erläuterung jedoch nur der vollständige Namen der jeweiligen chemischen Elemente angegeben. Die Diagramme D2 und D3 sind zwei verschiedenen Ausführungsformen gemäß Gegenstand der Erfindung zugeordnet und beschreiben also nicht die selbe Ausführungsform.

In dem ersten Diagramm D1 zeigt sich, dass die Gitterkonstante a beginnend von der ersten Halbleiter-Solarzelle G bis zu der fünften metamorphen Pufferschicht MP5 zunimmt und bei der sechsten metamorphen Pufferschicht MP6 abnimmt, um dann bei den nachfolgenden beiden Halbleiter-Solarzellen IGA und IGP konstant zu bleiben. Aus Gründen der Übersichtlichkeit ist der Verlauf der unverspannten Gitterkonstante a stufenförmig dargstellt. Es ist jedoch davon auszugehen, dass sich die in-plane Gitterkonstante a in den zumeist sehr dünnen Schichten nahezu kontinuierlich ändert. Als dünne Schichten werden vorliegend Schichten mit Dicken von kleiner als 600 nm bezeichnet. Im Unterschied zu dem Verlauf der Gitterkonstante a steigt die Energie der Bandlücke Eg von der ersten Halbleiter-Solarzelle G zu der ersten metamorphen Pufferschicht MP1 sprunghaft an. Im Verlauf von der ersten metamorphen Pufferschicht MP1 bis hin einschließlich der vierten metamorphen Pufferschicht MP4 verbleibt die Energie der Bandlücke Eg mit geringen Schwankungen auf dem Niveau der ersten metamorphen Pufferschicht MP1. Hierdurch wird eine ausreichende Transparenz des metamorphen Puffers gewährleistet. Ausgehend von der vierten metamorphen Pufferschicht MP4 hin zu der fünften metamorphen Pufferschicht MP5 fällt die Energie der Bandlücke Eg wiederum ab, verbleibt jedoch oberhalb des Ausgangsniveaus gegeben durch die erste Halbleiter-Solarzelle G. In dem weiteren Verlauf von der fünften metamorphen Pufferschicht MP5 hin zu der sechsten metamorphen Pufferschicht MP6 und zu der zweiten Halbleiter-Solarzelle IGA steigt die Energie der Bandlücke Eg stufenförmig weiter an.

Das zweite Diagramm D2 beschreibt eine erfindungsgemäße Ausbildung mit einem metamorphen Puffer aus AlInGaAs und InGaAs Schichten. In dem zweiten Diagramm D2 zeigt sich, dass nur die vierte metamorphe Pufferschicht MP4 einen stark erhöhten Aluminium Gehalt aufweist. Die unmittelbar mit der vierten metamorphen Pufferschicht MP4 verbundenen beiden metamorphen Pufferschichten MP3 und MP5 weisen ebenso wie die weiteren Schichten des metamorphen Puffers einen deutlich niedrigeren Aluminium-gehalt auf. Im Unterschied zu dem Verlauf des Aluminiumgehaltes steigt der Indiumgehalt zwischen der ersten metamorphen Pufferschicht MP1 bis einschließlich zu der fünften metamorphen Pufferschicht MP5 stufenförmig und analog zur Gitterkonstante a in Diagramm D1 an. Anschließend fällt ausgehend von der fünften metamorphen Pufferschicht MP5 hin zu der sechsten metamorphen Pufferschicht MP6 der Indiumgehalt wieder ab. Anders ausgedrückt weist die vierte metamorphe Pufferschicht MP4 den höchsten Aluminiumgehalt und den zweithöchsten Indiumgehalt in dem metamorphen Puffer auf. Es sei auch hier angemerkt, dass aus Gründen der Übersichtlichkeit die einzelnen Kompositionen in den jeweiligen Schichten als homogen dargestellt sind. Es versteht sich jedoch, dass an den Grenzflächen zwischen zwei aufeinanderliegenden Schichten sich die Komposition kontinuierlich ändert. Des Weiteren sei angemerkt, das vorliegend die vierte metamorphe Pufferschicht MP4 der eingangs in der Beschreibung erwähnten zweiten Schicht entspricht. Ferner entsprechen die eingangs in der Beschreibung erwähnten erste Schicht und die dritte Schicht vorliegend der dritten metamorphen Pufferschicht MP3 bzw. der fünften metamorphen Pufferschicht MP5.

Das dritte Diagramm D3 beschreibt eine erfindungsgemäße Ausbildung mit einem metamorphen Puffer aus InGaAs und InGaP Schichten In dem dritten Diagramm D3 verbleibt der Phosphorgehalt ausgehend von der ersten metamorphen Pufferschicht MP1 bis hin einschließlich zu der sechsten metamorphen Pufferschicht MP6, mit Ausnahme der vierten metamorphen Pufferschicht MP4, nahezu konstant. Die Schichten MP1 bis MP6 bestehen vorliegend aus Phosphiden. Die vierte metamorphe Pufferschicht MP4 weist vorliegend kein Phosphor auf. Im Unterschied dazu weist ausschließlich die vierte metamorphe Pufferschicht MP4 einen Arsengehalt auf. Anders ausgedrückt besteht die vierte metamorphe Pufferschicht MP4 aus Arseniden. Die Eigenschaften von Schicht MP4 lassen sich derart einstellen, dass sich eine im Vergleich zu den umgebenden metamorphen Pufferschichten MP3 und MP5 eine besonders geringe Nanohärte bzw. eine weiche Schicht herstellen lässt.

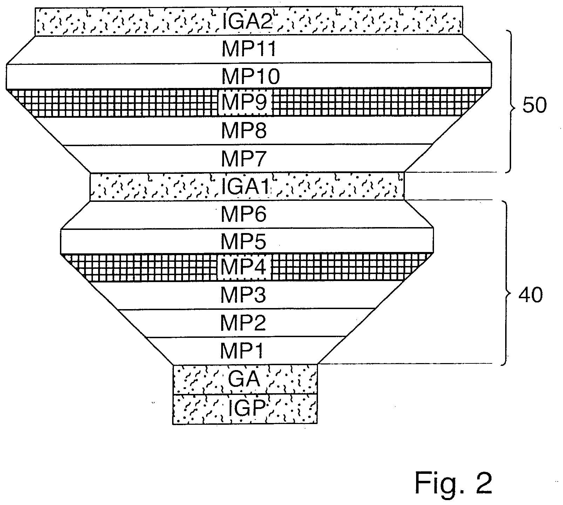

In der Abbildung der Figur 2 ist eine Ausführungsform mit einer Abfolge von zwei aufeinanderliegenden metamorphen Puffern dargestellt. Nachfolgend werden nur die Unterschiede zu der Ausführungsform der Figur 1 erläutert. Die Breite der einzelnen Schichten ist wieder als Maß für die Größe der Gitterkonstante anzusehen. Hiernach ist die Gitterkonstante des zweiten metamorphen Puffers 50 im Mittel größer als die Gitterkonstante im Mittel des ersten Puffers 40. Der erste metamorphe Puffer 40 ist zwischen der ersten Halbleiter-Solarzelle aus GA und der zweiten Halbleitersolarzelle aus IGA1 ausgebildet. Der zweite metamorphe Puffer 50 mit einer Abfolge von insgesamt fünf metamorphen Pufferschichten ist zwischen der zweiten Halbleiter-solarzelle IGA1 und der vierten Halbleitersolarzelle aus IGA2 ausgebildet, beginnend mit der siebten metamorphen Pufferschicht MP7 bis einschließlich der elften metamorphen Pufferschicht MP11. An die erste Halbleiter-Solarzelle GA schließt sich eine dritte Halbleitersolarzelle IGP an.

Bei dem zweiten metamorphen Puffer 50 entspricht die neunte metamorphe Pufferschicht MP9 der vierten metamorphen Pufferschicht MP4, wobei beide Schichten erfindungsgemäß entweder einen höheren Aluminium-Gehalt als die umgebenden Halbleiterschichten MP3 und MP5 bzw. MP8 und MP9 aufweisen oder im Gegensatz zu den anderen Halbleiterschichten MP1, MP2, MP3, MP5 und MP6 bzw. MP7, MP8, MP10 und MP11 aus einer Arsenid-Verbindung anstatt einer Phosphid-Verbindung bestehen. Hierdurch weist die neunte metamorphe Pufferschicht MP9 genauso wie die metamorphe Pufferschicht MP4 eine geringere Nanohärte als die beiden unmittelbar benachbarten metamorphen Pufferschichten MP8 und MP10 bzw. MP3 und MP4 auf. Anders ausgedrückt neben der vierten metamorphen Pufferschicht MP4 welche eine "Soll-Bruchstelle" ausbildet ist mit der neunten metamorphen Pufferschicht MP9 eine weitere "Soll-Bruchstelle" ausgebildet.

Ein Vorteil ist, dass mit der Herstellung einer Abfolge von multiplen metamorphen Puffern sich ohne weiters größere Gitterunterschiede von einzelnen Halbleiter-Solarzellen, welche in Situ aufeinander gestapelt werden sollen, ausgleichen lassen. Hierbei lassen sich mögliche Versetzungen in dem weicheren Schichten der metamorphen Puffern 40 und 50 zuverlässig einfangen.

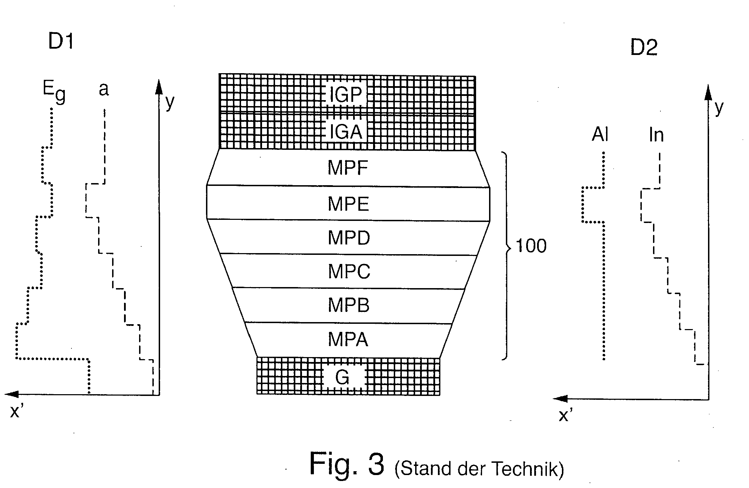

In der Figur 3 ist eine dem Stand der Technik gemäße Ausführungsform eines metamorphen Puffers 100 dargestellt. Vorliegend besteht der metamorphe InGaAs-Puffer 100 ebenfalls aus sechs metamorphen Pufferschichten MPA bis MPF. Der metamorphe Puffer 100 ist zwischen der ersten Halbleiter-Solarzelle G und der zweiten Halbleiter-Solarzelle IGA angeordnet. Die zweite Halbleiter-Solarzelle IGA ist von der dritten Halbleiter-Solarzelle IGP bedeckt.

Nachfolgend werden nur die Unterschiede zu der erfindungsgemäßen Ausführungsform dargestellt in der Figur 1 erläutert. Indem der metamorphe Puffer nur aus InGaAs und AlInGaAs besteht, sind vorliegend nur die beiden Diagramme D1 und D2 dargestellt. Während gemäß dem ersten Diagramm D1 der Verlauf der Gitterkonstanten a in erster Näherung dem Verlauf der Gitterkonstanten a der erfindungsgemäßen ersten Ausführungsform entspricht, zeigen sich bei einem Vergleich der beiden Verläufe der Bandlücken Eg Unterschiede. Zwar ist auch in dem Stand der Technik an der Grenzfläche zwischen der ersten Halbleiter-Solarzelle G und der metamorphen Pufferschicht MPA der Sprung in der Bandlücke Eg vergleichbar ausgebildet, jedoch nimmt in dem weiteren Verlauf die Größe der Bandlücke bis auf wenige geringe Erhöhungen quasi kontinuierlich ab, wobei letztlich die Bandlücke Eg der zweiten Halbleiter-Solarzelle noch erheblich oberhalb der Bandlücke Eg der ersten Halbleiter-Solarzelle G liegt. Ein starker Rückgang in der Größe der Bandlücke Eg etwa in der Mitte des metamorphen Puffers 100 ist jedoch in dem Stand der Technik gemäßen metamorphen Puffer 100 nicht ausgebildet.

Auch in dem Verlauf des Indium-Gehalts gemäß dem Diagramm D2 zeigt sich ein stufenförmiger Anstieg zwischen einer Schicht MPA und einer Schicht MPE. Bei dem Verlauf des Aluminium-Gehaltes gibt es jedoch Unterschiede zum erfindungsgemäßen Verlauf, d.h. bei dem Stand der Technik wird den Schichten MPA bis MPF Aluminium beigemischt, um die Bandlücke der Pufferschichten zu erhöhen und die Transparenz des metamorphen Puffers zu verbessern. Da InGaAs Schichten mit höherem Indium-Gehalt eine geringere Bandlücke aufweisen ist insbesondere bei Schichten hohem Indium-Gehalt auch ein hoher Aluminium-Gehalt wünschenswert. Da die Schicht MPE im vorliegenden Fall eine größere Gitterkonstante als die zweite Halbleitersolarzelle IGA aufweist, ist insbesondere für Schicht MPE ein hoher Aluminium-Gehalt erforderlich um die gewünschte Transparenz zu gewährleisten. Im Unterschied zum Gegenstand der Erfindung wird der Aluminium-Gehalt bei Schichten mit größerem Indium-Gehalt jedoch nicht wieder reduziert.

## Patentansprüche

1. Solarzellenstapel (10) aufweisend
- eine erste Halbleiter-Solarzelle (G), wobei die erste Halbleiter-Solarzelle (G) einen p-n Übergang aus einem ersten Material mit einer ersten Gitterkonstanten aufweist, und
- eine zweite Halbleiter-Solarzelle (IGA), wobei die zweite Halbleiter-Solarzelle (IGA) einen p-n Übergang aus einem zweiten Material mit einer zweiten Gitterkonstanten aufweist, und
- die erste Gitterkonstante kleiner als die zweite Gitterkonstante ist, und
- einen metamorphen Puffer (40) wobei der metamorphe Puffer (40) eine Abfolge von aufeinanderfolgenden Schichten mit einer ersten unteren Schicht (MP3) und einer zweiten mittleren Schicht (MP4) und einer dritten oberen Schicht (MP5) umfasst und der metamorphe Puffer (40) eine InGaAs und/oder eine AlInGaAs und/oder eine InGaP und/oder eine AlInGaP-Verbindung umfasst und der metamorphe Puffer (40) zwischen der ersten Halbleiter-Solarzelle (G) und der zweiten Halbleiter-Solarzelle (IGA) ausgebildet ist und bei dem metamorphen Puffer (40) sich entlang seiner Dickenerstreckung die Gitterkonstante (a) ändert,
**dadurch gekennzeichnet, dass**
die zweite Schicht (MP4) einen höheren Al - Gehalt, als die erste Schicht (MP3) und als die dritte Schicht (MP5) aufweist, und / oder die zweite Schicht (MP4) einen geringeren Phosphorgehalt als die erste Schicht (MP3) und die dritte Schicht (MP5) aufweist,
- und die Gitterkonstante der dritten Schicht (MP5) größer als die Gitterkonstante der zweiten Schicht (MP4) und die Gitterkonstante der zweiten Schicht (MP4) größer als die Gitterkonstante der ersten Schicht (MP3) ist, und
die erste Schicht (MP3) und die dritte Schicht (MP5) eine größere Nanohärte als die zweite Schicht (MP4) aufweist.

2. Solarzellenstapel (10) nach Anspruch 1, **dadurch gekennzeichnet, dass** die Gitterkonstante des metamorphen Puffers (40) in Richtung der zweiten Halbleitersolarzelle (IGA) von Schicht zu Schicht um jeweils mindestens 0,003 A ansteigt.

3. Solarzellenstapel (10) nach Anspruch 1, **dadurch gekennzeichnet, dass** die Gitterkonstante des metamorphen Puffers (40) in Richtung der zweiten Halbleitersolarzelle (IGA) von Schicht zu Schicht um jeweils mindestens 0,005 Å ansteigt.

4. Solarzellenstapel (10) nach einem der vorangegangenen Ansprüche, **dadurch gekennzeichnet, dass** eine Schicht des metamorphen Puffers (40) eine dritte Gitterkonstante aufweist und die dritte Gitterkonstante größer ist als die Gitterkonstante der zweiten Halbleiter-Solarzelle (IGA).

5. Solarzellenstapel (10) nach einem der vorangegangenen Ansprüche, **dadurch gekennzeichnet, dass** die zweite Schicht (MP4) des metamorphen Puffers (40) eine gleich große Gitterkonstante wie die zweite Halbleitersolarzelle (IGA) aufweist oder die zweite Schicht (MP4) des metamorphen Puffers (40) eine um maximal 0,008 Å größere Gitterkonstante als die zweite Halbleitersolarzelle (IGA) aufweist.

6. Solarzellenstapel (10) nach einem der vorangegangenen Ansprüche, **dadurch gekennzeichnet, dass** die zweite Schicht (MP4) eine größere Gitterkonstante als die erste Halbleiter-Solarzelle (G) aufweist.

7. Solarzellenstapel (10) nach einem der vorangegangenen Ansprüche, **dadurch gekennzeichnet, dass** eine vierte Schicht (MP6) vorgesehen ist und die vierte Schicht (MP6) oberhalb der dritten Schicht (MP5) angeordnet und stoffschlüssig mit der dritten Schicht (MP5) verbunden ist und die vierte Schicht (MP6) eine kleinere Gitterkonstante als die zweite Halbleitersolarzelle (IGA) aufweist.

8. Solarzellenstapel (10) nach einem der vorangegangenen Ansprüche, **dadurch gekennzeichnet, dass** der AI-Gehalt der zweiten Schicht (MP4) größer als der Al-Gehalt aller anderen Schichten (MP1, MP2, MP3, MP5, MP6) des metamorphen Puffers (40) ist.

9. Solarzellenstapel (10) nach einem der vorangegangenen Ansprüche, **dadurch gekennzeichnet, dass** innerhalb der Abfolge von drei Schichten (MP1, MP2, MP3, MP4, MP5, MP6) des metamorphen Puffers (40) nur InGaAs-Schichten oder AlInGaAs-Schichten ausgebildet sind.

10. Solarzellenstapel (10) nach einem der vorangegangenen Ansprüche, **dadurch gekennzeichnet, dass** innerhalb der Abfolge von drei Schichten (MP1, MP2, MP3, MP4, MP5, MP6) des metamorphen Puffers (40) nur InGaP-Schichten oder AlInGaP-Schichten ausgebildet sind.

11. Solarzellenstapel (10) nach einem der vorangegangenen Ansprüche, **dadurch gekennzeichnet, dass** die erste Schicht (MP3) mit der zweiten Schicht (MP4) und die zweite Schicht (MP4) mit der dritten Schicht (MP5) stoffschlüssig verbunden ist.

12. Solarzellenstapel (10) nach einem der vorangegangenen Ansprüche, **dadurch gekennzeichnet, dass** eine dritte Halbleiter-Solarzelle vorgesehen ist und zwischen der zweiten Halbleiter-Solarzelle (IGA) und der dritten Halbleiter-Solarzelle ein weiterer metamorpher Puffer (50) ausgebildet ist oder zwischen der ersten Halbleiter-Solarzelle (G) und der zweiten Halbleiter-Solarzelle (IGA) zusätzlich zu dem metamorphen Puffer (40) ein weiterer metamorpher Puffer (50) ausgebildet ist.

13. Solarzellenstapel (10) nach einem der vorangegangenen Ansprüche, **dadurch gekennzeichnet, dass** jede der Halbleiter-Solarzellen (G, IGP, IGA, IGA1, IGA2) einen pn-Übergang beinhaltet.

14. Solarzellenstapel (10) nach einem der vorangegangenen Ansprüche, **dadurch gekennzeichnet, dass** die zweite Schicht (MP4) keine Nitrid-verbindung umfasst.

15. Solarzellenstapel (10) nach einem der vorangegangenen Ansprüche, **dadurch gekennzeichnet, dass** die metamorphen Pufferschichten nicht Teil eines pn-Übergangs einer Tunneldiode sind.

## Claims

1. Solar cell stack (10) comprising
- a first semiconductor solar cell (G), wherein the first semiconductor solar cell (G) has a p-n transition of a first material with a first lattice constant and
- a second semiconductor solar cell (IGA), wherein the second semiconductor solar cell (IGA) has a p-n transition of a second material with a second lattice constant and
- the first lattice constant is smaller than the second lattice constant, and
- a metamorphic buffer (40), wherein the metamorphic buffer (40) comprises a sequence of successive layers with a first, lower layer (MP3) and a second, middle layer (MP4) and a third, upper layer (MP5) and the metamorphic buffer (40) comprises an InGaAs and/or an AlIGaAs and/or an InGaP and/or an AlInGaP compound and the metamorphic buffer (40) is formed between the first semiconductor solar cell (G) and the second semiconductor solar cell (IGA) and in the metamorphic buffer (40) the lattice constant (a) changes along its thickness dimension,
**characterised in that**
the second layer (MP4) has a higher Al content than the first layer (MP3) and than the third layer (MP5),
and/or the second layer (MP4) has a lower phosphor content than the first layer (MP3) and the third layer (MP5),
and the lattice constant of the third layer (MP5) is greater than the lattice constant of the second layer (MP4) and the lattice constant of the second layer (MP4) is greater than the lattice constant of the first layer (MP3) and
the first layer (MP3) and the third layer (MP5) have a greater nano-hardness than the second layer (MP4).

2. Solar cell stack (10) according to claim 1, **characterised in that** the lattice constant of the metamorphic buffer (40) increases in the direction of the second semiconductor solar cell (IGA) from layer to layer each time by at least 0.003 Å.

3. Solar cell stack (10) according to claim 1, **characterised in that** the lattice constant of the metamorphic buffer (40) increases in the direction of the second semiconductor solar cell (IGA) from layer to layer each time by at least 0.005 Å.

4. Solar cell stack (10) according to any one of the pre preceding claims, **characterised in that** a layer of the metamorphic buffer (40) has a third lattice constant and the third lattice constant is greater than the lattice constant of the second semiconductor solar cell (IGA).

5. Solar cell stack (10) according to any one of the pre preceding claims, **characterised in that** the second layer (MP4) of the metamorphic buffer (40) has a lattice constant which is the same as that of the second semiconductor solar cell (IGA) or the second layer (MP4) of the metamorphic buffer (40) has a lattice constant which is greater by at most 0.008 Å than that of the second semiconductor solar cell (IGA).

6. Solar cell stack (10) according to any one of the pre preceding claims, **characterised in that** the second layer (MP4) has a greater lattice constant than the first semiconductor solar cell (G).

7. Solar cell stack (10) according to any one of the pre preceding claims, **characterised in that** a fourth layer (MP6) is provided and the fourth layer (MP6) is arranged above the third layer (MP5) and is connected with the third layer (MP5) by material couple and the fourth layer (MP6) has a smaller lattice constant than the second semiconductor solar cell (IGA).

8. Solar cell stack (10) according to any one of the pre preceding claims, **characterised in that** the Al content of the second layer (MP4) is greater than the Al content of all other layers (MP1, MP2, MP3, MP5, MP6) of the metamorphic buffer (40).

9. Solar cell stack (10) according to any one of the pre preceding claims, **characterised in that** only InGaAs layers or AlInGaAs layers are formed within the sequence of three layers (MP1, MP2, MP3, MP4, MP5, MP6) of the metamorphic buffer (40).

10. Solar cell stack (10) according to any one of the pre preceding claims, **characterised in that** only InGaP layers or AlInGaP layers are formed within the sequence of three layers (Mp1, MP2, MP3, MP4, MP5, MP6) of the metamorphic buffer (40).

11. Solar cell stack (10) according to any one of the pre preceding claims, **characterised in that** the first layer (MP3) is connected with the second layer (MP4) by material couple and the second layer (MP4) is connected with the third layer (MP5) by material couple.

12. Solar cell stack (10) according to any one of the pre preceding claims, **characterised in that** a third semiconductor solar cell is provided and a further metamorphic buffer (50) is formed between the second semiconductor solar cell (IGA) and the third semiconductor solar cell or a further metamorphic buffer (50) is formed between the first semiconductor solar cell (G) and the second semiconductor solar cell (IGA) additionally to the metamorphic buffer (40).

13. Solar cell stack (10) according to any one of the pre preceding claims, **characterised in that** each of the semiconductor solar cells (G, IGP, IGA, IGA1, IGA2) includes a p-n transition.

14. Solar cell stack (10) according to any one of the pre preceding claims, **characterised in that** the second layer (MP4) does not comprises a nitride compound.

15. Solar cell stack (10) according to any one of the pre preceding claims, **characterised in that** the metamorphic buffer layers are not part of a p-n transition of a tunnel diode.

## Revendications

1. Empilement de cellules solaires (10) présentant
- une première cellule solaire à semi-conducteur (G), dans lequel la première cellule solaire à semi-conducteur (G) présente une transition p-n en un premier matériau avec une première constante de réseau, et
- une deuxième cellule solaire à semi-conducteur (IGA), dans lequel la deuxième cellule solaire à semi-conducteur (IGA) présente une transition p-n en un deuxième matériau avec une deuxième constante de réseau, et
- la première constante de réseau est plus petite que la deuxième constante de réseau, et
- un tampon métamorphe (40), dans lequel le tampon métamorphe (40) comprend une succession de couches successives avec une première couche inférieure (MP3) et une deuxième couche moyenne (MP4) et une troisième couche supérieure (MP5) et le tampon métamorphe (40) comprend un composé InGaAs et/ou un composé AlInGaAs et/ou un composé InGaP et/ou un composé AlInGaP et le tampon métamorphe (40) est formé entre la première cellule solaire à semi-conducteur (G) et la deuxième cellule solaire à semi-conducteur (IGA) et la constante de réseau (a) varie dans le tampon métamorphe (40) le long de sa dimension d'épaisseur,
**caractérisé en ce que**
- la deuxième couche (MP4) présente une teneur en Al plus élevée que la première couche (MP3) et que la troisième couche (MP5), et/ou la deuxième couche (MP4) présente une teneur en phosphore moins élevée que la première couche (MP3) et que la troisième couche (MP5), et
- la constante de réseau de la troisième couche (MP5) est plus grande que la constante de réseau de la deuxième couche (MP4) et la constante de réseau de la deuxième couche (MP4) est plus grande que la constante de réseau de la première couche (MP3), et
- la première couche (MP3) et la troisième couche (MP5) présentent une nanodureté plus élevée que la deuxième couche (MP4).

2. Empilement de cellules solaires (10) selon la revendication 1, **caractérisé en ce que** la constante de réseau du tampon métamorphe (40) augmente de couche en couche d'au moins chaque fois 0,003 Å en direction de la deuxième cellule solaire à semi-conducteur (IGA).

3. Empilement de cellules solaires (10) selon la revendication 1, **caractérisé en ce que** la constante de réseau du tampon métamorphe (40) augmente de couche en couche chaque fois d'au moins 0,005 Å en direction de la deuxième cellule solaire à semi-conducteur (IGA).

4. Empilement de cellules solaires (10) selon l'une quelconque des revendications précédentes, **caractérisé en ce qu'**une couche du tampon métamorphe (40) présente une troisième constante de réseau et la troisième constante de réseau est plus grande que la constante de réseau de la deuxième cellule solaire à semi-conducteur (IGA).

5. Empilement de cellules solaires (10) selon l'une quelconque des revendications précédentes, **caractérisé en ce que** la deuxième couche (MP4) du tampon métamorphe (40) présente une constante de réseau égale à celle de la deuxième cellule solaire à semi-conducteur (IGA) ou la deuxième couche (MP4) du tampon métamorphe (40) présente une constante de réseau supérieure au maximum de 0,008 Å à celle de la deuxième cellule solaire à semi-conducteur (IGA).

6. Empilement de cellules solaires (10) selon l'une quelconque des revendications précédentes, **caractérisé en ce que** la deuxième couche (MP4) présente une plus grande constante de réseau que la première cellule solaire à semi-conducteur (G).

7. Empilement de cellules solaires (10) selon l'une quelconque des revendications précédentes, **caractérisé en ce qu'**il est prévu une quatrième couche (MP6) et la quatrième couche (MP6) est disposée au-dessus de la troisième couche (MP5) et est liée matériellement à la troisième couche (MP5) et la quatrième couche (MP6) présente une plus petite constante de réseau que la deuxième cellule solaire à semi-conducteur (IGA).

8. Empilement de cellules solaires (10) selon l'une quelconque des revendications précédentes, **caractérisé en ce que** la teneur en A1 de la deuxième couche (MP4) est plus élevée que la teneur en A1 de toutes les autres couches (MP1, MP2, MP3, MP5, MP6) du tampon métamorphe (40).

9. Empilement de cellules solaires (10) selon l'une quelconque des revendications précédentes, **caractérisé en ce que** seules des couches de InGaAs ou seules des couches de AlInGaAs sont formées à l'intérieur de la succession de trois couches (MP1, MP2, MP3, MP4, MP5, MP6) du tampon métamorphe (40).

10. Empilement de cellules solaires (10) selon l'une quelconque des revendications précédentes, **caractérisé en ce que** seules des couches de InGaP ou seules des couches de AlInGaP sont formées à l'intérieur de la succession de trois couches (MP1, MP2, MP3, MP4, MP5, MP6) du tampon métamorphe (40).

11. Empilement de cellules solaires (10) selon l'une quelconque des revendications précédentes, **caractérisé en ce que** la première couche (MP3) est liée matériellement à la deuxième couche (MP4) et la deuxième couche (MP4) est liée matériellement à la troisième couche (MP5).

12. Empilement de cellules solaires (10) selon l'une quelconque des revendications précédentes, **caractérisé en ce qu'**il est prévu une troisième cellule solaire à semi-conducteur et un autre tampon métamorphe (50) est formé entre la deuxième cellule solaire à semi-conducteur (IGA) et la troisième cellule solaire à semi-conducteur ou un autre tampon métamorphe (50) est formé en plus du tampon métamorphe (40) entre la première cellule solaire à semi-conducteur (G) et la deuxième cellule solaire à semi-conducteur (IGA).

13. Empilement de cellules solaires (10) selon l'une quelconque des revendications précédentes, **caractérisé en ce que** chacune des cellules solaires à semi-conducteur (G, IGP, IGA, IGA1, IGA2) contient une transition pn.

14. Empilement de cellules solaires (10) selon l'une quelconque des revendications précédentes, **caractérisé en ce que** la deuxième couche (MP4) ne contient aucun composé nitrure.

15. Empilement de cellules solaires (10) selon l'une quelconque des revendications précédentes, **caractérisé en ce que** les couches tampons métamorphes ne font pas partie d'une transition pn d'une diode tunnel.
